# EUROPEAN PATENT SPECIFICATION

(11) **EP 2 187 708 B1**
(45) Date of publication and mention of the grant of the patent: **23.01.2013**
(21) Application number: 08830220.3
(22) Date of filing: 08.09.2008
(51) Int. Cl.: H05B 33/10, C23C 14/12, H01L 51/50, C23C 14/24, C23C 14/22

(54) **FILM DEPOSITION APPARATUS WITH ORGANIC-MATERIAL VAPOR GENERATOR**
FILMBESCHICHTUNGSVORRICHTUNG MIT VERDAMPFER FÜR ORGANISCHES MATERIAL
APPAREIL DE DÉPÔT DE FILM AVEC VAPORISATEUR DE MATÉRIAU ORGANIQUE

(30) Priority: 10.09.2007 JP 2007234441; 25.02.2008 JP 2008043480
(43) Date of publication of application: 19.05.2010
(73) Proprietor: Ulvac, Inc., Chigasaki-shi Kanagawa 253-8543 (JP)
(72) Inventor: NEGISHI, Toshio, Chigasaki-shi Kanagawa 253-8543 (JP)
(74) Representative: Körber, Martin Hans
(86) International application number: PCT/JP2008/066149
(87) International publication number: WO 2009/034938

(56) References cited:
- EP-A2- 1 413 644
- WO-A1-2007/029671
- JP-A- 06 206 796
- JP-A- 07 268 634
- JP-A- 2001 308 082
- JP-A- 2003 147 529
- JP-A- 2003 268 552
- JP-A- 2003 347 047
- JP-A- 2004 204 289
- JP-A- 2005 158 954
- JP-A- 2006 152 326
- JP-A- 2007 119 913
- US-A1- 2007 054 051

## Description

### Technical Field

The present invention relates to a technique to form an organic thin film, and specifically relates to an organic material vapor generator to form an organic thin film, a film forming source having the organic material vapor generator, and a film forming apparatus having the film forming source.

### Background Art

Organic EL elements are one of the most popular display elements in recent years for having excellent characteristics of high brightness and high response speed.

In a color display panel using organic EL elements, light-emitting regions that produce three different colors of red, green and blue are disposed on a glass substrate. The light-emitting regions are configured by laminating an anode electrode film made of a metal thin film, a hole injection layer, a hole transport layer, a light-emitting layer, and an electron transport layer made of organic thin films, and an electron injection layer and a cathode electrode film made of metal thin films in this order to emit light having a color of red, green, blue, or an auxiliary yellow depending on a color producing reagent added into the light-emitting layer.

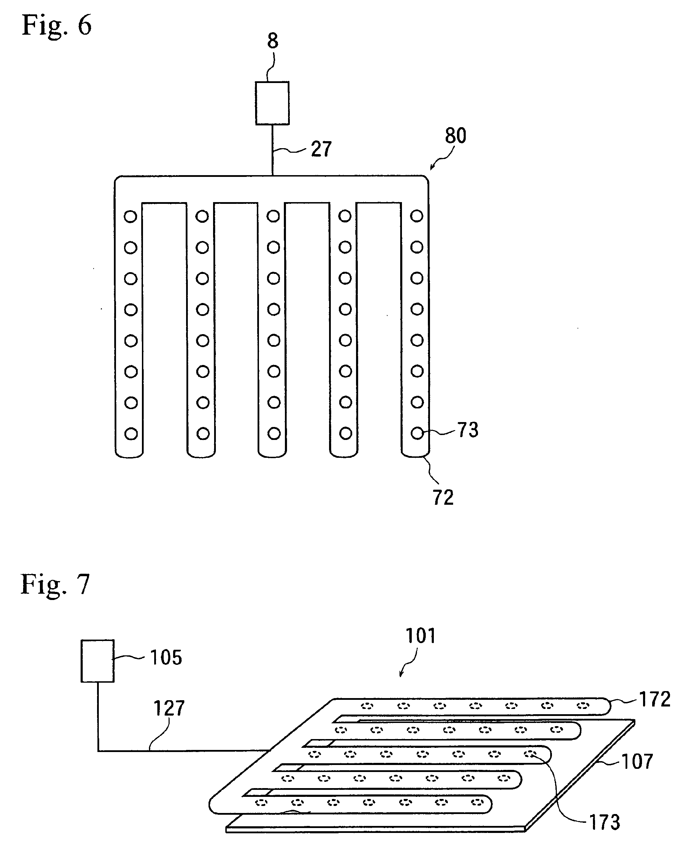

In order to form such an organic thin film, a discharger 101 of organic material vapor as illustrated in a perspective view of Fig. 7 is used.

The discharger 101 has vapor discharge pipes 172 in the form of a pipe. The vapor discharge pipes 172 are connected, via a supply pipe 127, to a discharge unit 105 in which organic material vapor is produced. When organic material vapor is supplied from the production unit 105, the organic material vapor is discharged from discharge orifices 173 formed in a large number on the vapor discharge pipes 172 in a longitudinal direction thereof towards an object 107 to be film-formed, and as the organic material vapor reaches the object to be film-formed 107, an organic thin film is formed on the surface.

However, in the above discharger 101, the amount of the organic material vapor discharged from the discharge orifices 173 sometimes differs in a portion near and a portion far from the position connected to the production unit 105 among the vapor discharge pipes 172. Therefore, there is a problem of poor film thickness distribution of the organic thin film formed on the surface of the object to be film-formed 107.

Particularly when a substrate having large scale is the object to be film-formed, the object to be film-formed cannot be rotated, so that it is difficult to make the film thickness distribution uniform.

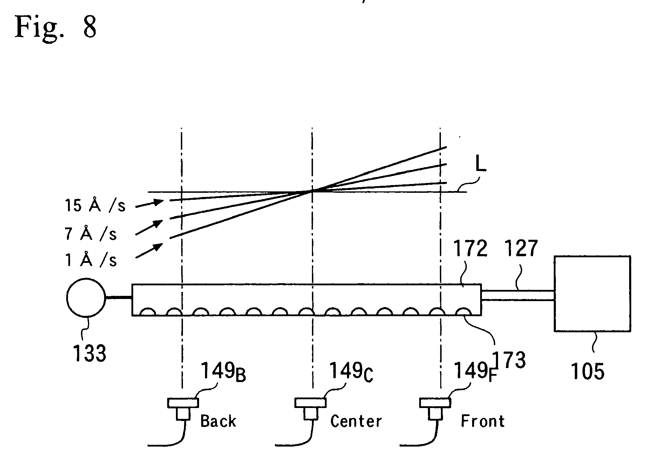

In Fig. 8, film thickness monitors 149_{F}, 149_{C} and 149_{B} are disposed at positions facing a base portion (Front) near the portion where the vapor discharge pipe 172 is connected to the supply pipe 127, a center portion (Center), and an end portion (Back) most distant from the portion when the vapor discharge pipe 172 are respectively connected to the supply pipe 127. Only an organic material vapor is introduced into the vapor discharge pipe 172 without using a carrier gas, and film thickness ratios of thin films formed at each of the positions are obtained by varying the film deposition rate.

The result is shown in Table 1 below. The film thickness of the center portion is expressed as "1".

**Table 1**

| Relationship between film deposition rate and film thickness rate | | | |
|---|---|---|---|
| Film deposition rate | Film thickness ratio | | |
| | Back | Center | Front |
| 1 Å /s | 0.77 | 1.0 | 1.39 |
| 7 Å /s | 0.88 | 1.0 | 1.08 |
| 15 Å /s | 0.98 | 1.0 | 1.01 |

A graph of the film thickness distribution corresponding to Table 1 above is drawn at a position above the vapor discharge pipe 172 in Fig. 8. In the drawing, L represents a horizontal axis that indicates the film thickness ratio "1".

It is found that, as the film deposition rate is low, (that is, as the level of the molecular flow is intensified), the film thickness ratio on the base portion side becomes large. At the film deposition rate of 15 Å/second, the film is formed generally uniformly.

However, at the film deposition rate of 15 Å/second, it is difficult to control each film thickness within a desired range because it is excessively fast. When the film deposition rate is fast, the formed film is prone to be sparse and a dense organic film may not be obtained. In order to obtain a desired film thickness and a desired film quality, a film deposition rate of 7 Å/second or less is desirable.

Conventional arts to form an organic thin film using a carrier gas include below:
[Patent Document 1] JP 2001-523768 T
[Patent Document 2] JP 2003-525349 T
[Patent Document 3] JP 2004-204289 A
[Patent Document 4] JP 2005-29885 T
[Patent Document 5] JP 2006-111920 A

JP 2006/52326, US 20070054051 and JP 2003347047 disclose evaporators of organic raw material using a carier gas to coat large surfaces.

JP 2001-308082 shows the intraduction of organic raw material using a vaforiser, where the acrosol falls an a heated inclined surface.

### Disclosure of the Invention

### Problems to be Solved by the Invention

A problem of the present invention provides a technique that can form a uniform thin film even on a substrate that is large in scale.

### Means for Solving the Problems

To solve the problem described above, the present invention is a film forming apparatus, as disclosed in claim 1.

Furthermore, the film forming apparatus, is an apparatus wherein the vapor discharge pipe is horizontally disposed, the discharge orifices are directed below, and an object to be film-formed carried in the vacuum chamber is disposed below the vapor discharge pipe.

Furthermore, the film forming apparatus, is an apparatus including a plurality of the vapor discharge pipes disposed parallel to each other; and a shifter relatively moving the object to be film-formed and the vapor discharge pipe in a direction perpendicular to an extending direction of the vapor discharge pipe and in the horizontal direction.

The present invention is configured as discussed above, and when the organic material is scattered on the inclined evaporation surface to be evaporated due to the heat transfer from the evaporation surface, the heated carrier gas is sprayed to the produced organic material vapor and the organic material vapor is carried in a state such that the organic material vapor and the carrier gas are mixed. Thus, the mixed gas of the carrier gas and the organic material vapor is introduced into the vapor discharge pipe.

In the present invention, the pressure of the film forming chamber during film formation is preferably in the range of 10⁻⁴ Pa to 10⁻² Pa. In order to obtain a good film quality, the pressure of the film forming chamber is preferably controlled so as to be a pressure such that a mean free path is larger than the distance between the discharge orifice and the substrate. The supply amount of the organic material is determined such that the film deposition rate becomes 7 Å/second or less. The supply amount of the carrier gas is determined such that the internal pressure of the vapor discharge pipe becomes a pressure for discharging the gas generally uniformly from the discharge orifices that are aligned longitudinally.

The evaporation chamber is heated to a temperature higher than the evaporation temperature in order to prevent generating a portion at a temperature lower than the evaporation temperature of the organic material inside the evaporation chamber. Furthermore, the supply pipe and the vapor discharge pipe are also heated to a temperature higher than the evaporation temperature so that the organic material vapor does not deposit until the organic material vapor is discharged from the vapor discharge pipe.

### Effect of the Invention

Since the organic material vapor is discharged in the same amount per unit time from the base position through the end position of the elongate vapor discharge pipe, an organic thin film having a good film thickness distribution is formed.

Since the organic material vapor produced in the evaporation chamber is carried to the discharger by the carrier gas, the residual amount inside the evaporation chamber is small, and when the supply of the organic material vapor is stopped, the film formation can be immediately stopped.

### Brief Description of the Drawings

Fig. 1 shows one example of a vacuum processing apparatus having a film forming apparatus of the present invention;
Fig. 2 shows a diagram to illustrate a film forming chamber included in the film forming apparatus of the present invention;
Fig. 3 shows a diagram to illustrate an organic material vapor generator of a first example of the present invention;
Fig. 4 shows a diagram to illustrate an organic material vapor generator of a second example of the present invention;
Fig. 5 shows a diagram to illustrate an organic material vapor generator of a third example of the present invention;
Fig. 6 shows a diagram to illustrate a vapor discharge pipe;
Fig. 7 shows a diagram to illustrate a discharger of a technique for use in a discussion of the background art;
Fig. 8 is a chart to show the relationship between a position of a vapor discharge pipe and a film deposition rate in a case in which carrier gas is absent; and
Fig. 9 is a graph to show the relationship between a supply cycle of an organic material and a cycle of a film deposition rate.

### Explanation of Reference Numerals

- 8.: organic material vapor generator
- 9.: film forming chamber
- 10a to 10c.: film forming apparatuses
- 20a.: evaporation chamber
- 23.: connection pipe
- 24.: evaporation device
- 27.: supply pipe
- 28.: evaporation surface
- 30a to 30c: gas heating units
- 32.: heating filter
- 40.: supply unit
- 41.: tank chamber
- 42.: raw material supply pipe
- 48.: organic material
- 71.: vacuum chamber
- 72.: vapor discharge pipe

### Best Modes for Carrying Out the Invention

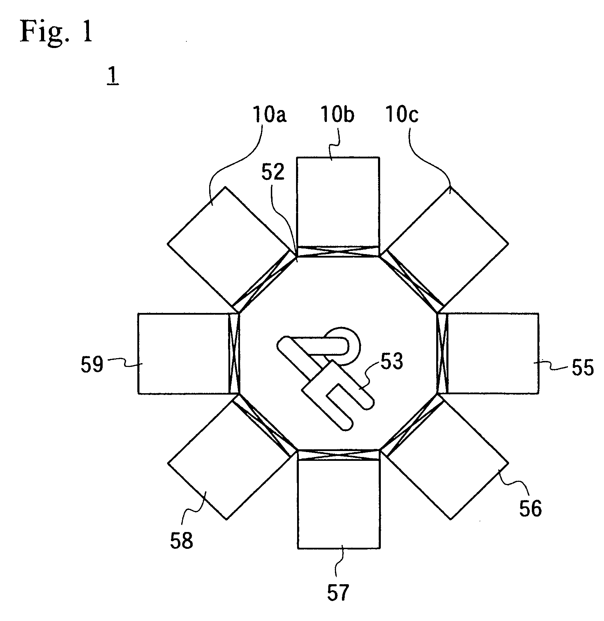

A reference numeral 1 in Fig. 1 denotes a vacuum processing apparatus having film forming apparatuses 10a to 10c of the present invention.

This vacuum processing apparatus 1 has a transfer chamber 52, to which the film forming apparatuses 10a, 10b and 10c corresponding to R, G and B, respectively, and other processing apparatuses 55 to 58 and a carry-in and out chamber 59 are connected.

Each chamber or each of the apparatuses 10a to 10c, 52, and 55 to 59 is respectively connected to a vacuum evacuator and the inside is evacuated to a vacuum ambience.

Inside the transfer chamber 52, a substrate transfer robot 53 is disposed. The substrate transfer robot 53 carries a substrate to be film-formed in and out between each chamber or each of the apparatuses 10a to 10c and 55 to 59 while maintaining the vacuum ambience.

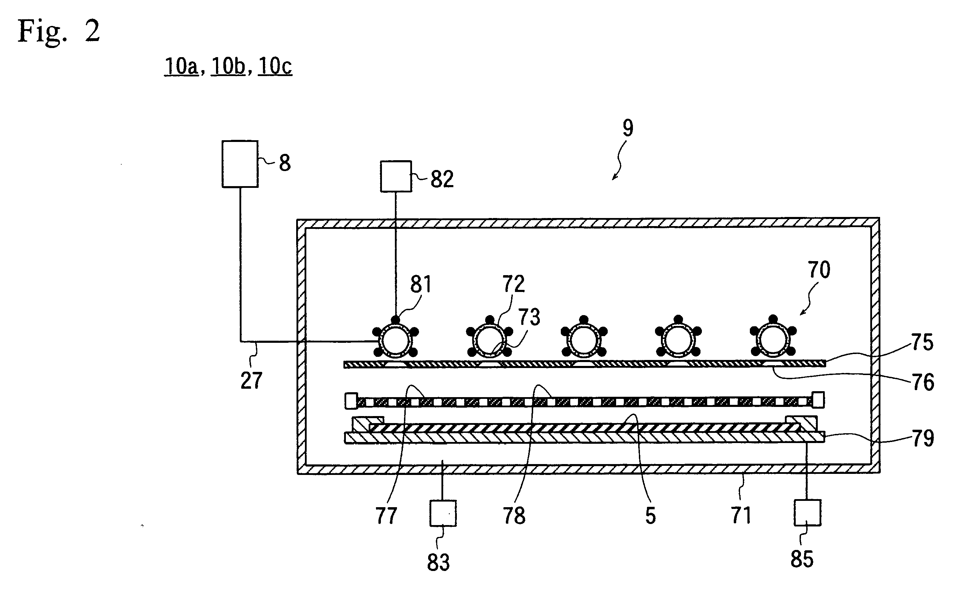

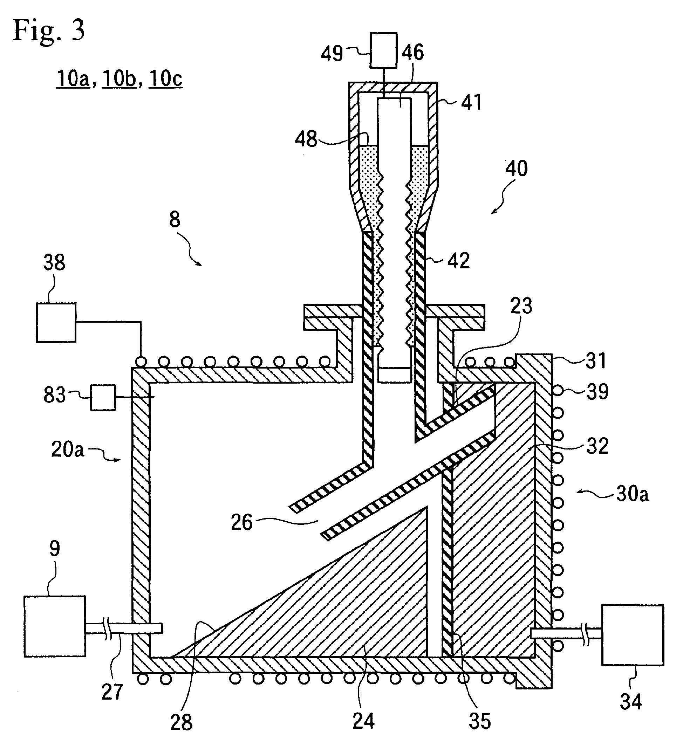

The three film forming apparatuses 10a to 10c have an identical apparatus configuration and the members in common are illustrated with same reference numerals. Each of the film forming apparatuses 10a to 10c has an organic material vapor generator 8 and a film forming chamber 9, as illustrated in Fig. 2 and Fig. 3. Fig. 2 illustrates inside the film forming chamber 9 and Fig. 3 shows inside the organic material vapor generator 8.

In reference to Fig. 2, a description will be given to the film forming chamber 9. The film forming chamber 9 has a vacuum chamber 71. A vacuum evacuation system 83 is connected to the vacuum chamber 71, and the inside of the vacuum chamber 71 is evacuated to a vacuum ambience by the vacuum evacuation system 83. During the film formation, the vacuum evacuation in the film forming chamber 9 is continuously performed.

Inside the vacuum chamber 71, a discharger 70 is disposed. The discharger 70 has a plurality of elongate vapor discharge pipes 72. Each vapor discharge pipe 72 is provided with a plurality of discharge orifices 73 along longitudinal directions thereof; and the inside of the vapor discharge pipe 72 is connected to an ambience that surrounds the vapor discharge pipe 72 via the discharge orifices 73.

As illustrated in Fig. 6, each vapor discharge pipe 72 is disposed at equal intervals parallel to each other. Here, each vapor discharge pipe 72 is disposed so as to be positioned on an identical plane.

Each vapor discharge pipe 72 shares a common base portion, and a supply pipe 27 is connected to that portion. Each vapor discharge pipe 72 is connected to the organic material vapor generator 8 by the supply pipe 27, and as described later, organic material vapor generated in the organic material vapor generator 8 is introduced into the inside of each vapor discharge pipe 72 from the base portion through the supply pipe 27.

Here, the end portion of each vapor discharge pipe 72 is blocked; and the entire amount of the gas introduced into the vapor discharge pipe 72 is discharged from each discharge orifice 73 into the vacuum chamber 71 while flowing through each vapor discharge pipe 72. Although the discharge orifices 73 are in the same size in the present Example, the size may also be varied for flow rate adjustment. The intervals between the discharge orifices 73 may also be varied.

Inside the vacuum chamber 71, a substrate holder 79 is disposed. On the substrate holder 79, a substrate 5 subjected to film formation is disposed.

A mask 77 is disposed over a surface of the substrate 5, and the discharger 70 is disposed above the mask 77 for sandwiching a cooling plate 75 therebetween. Here, the substrate 5 is horizontally disposed with the surface directed vertically above, and the discharger 70 is horizontally disposed vertically above the substrate 5. The cooling plate 75 and the mask 77 are disposed horizontally between the discharger 70 and the substrate 5.

Each vapor discharge pipe 72 is provided with heaters 81 and the heaters 81 are electrified by a heating power source 82 to heat the vapor discharge pipe 72. The cooling plate 75 is disposed between the discharger 70 and the mask 77 in order to prevent the mask 77 from being heated resulting from the heat of the heaters 81.

The discharge orifices 73 of each vapor discharge pipe 72 are directed in a direction of the substrate 5 being positioned, and the discharge orifices 73 are disposed at positions in a matrix so as to correspond to the substrate 5 having a rectangular shape. At positions of the cooling plate 75 facing straight toward the discharge orifices 73, passage holes 76 are provided and the gas discharged from the discharge orifices 73 reaches the mask 77 through the passage holes 76.

In the mask 77, through holes 78 are disposed in a predetermined pattern; and of the gas that reaches the mask 77, the gas passing through the through holes 78 reaches the substrate 5 so as to be in contact with the surface of the substrate 5.

As discussed later, organic material vapor is contained in the gas discharged from the discharge orifices 73, and at positions of the surface of the substrate 5 facing straight the through holes 78, an organic thin film corresponding to the pattern of the through holes 78 is formed.

When gas is discharged from the vapor discharge pipes 72, the vacuum chamber 71 is continuously vacuum-evacuated prior to such discharge, and residual gases not necessary for configuring the organic thin film are removed from the vacuum chamber 71 by the vacuum evacuation.

Next, in reference to Fig. 3, a description will be given to an organic material vapor generator 8 as the first example of the present invention. The organic material vapor generator 8 has an evaporation chamber 20a that evaporates an organic material and a supply unit 40 that supplies the organic material to the evaporation chamber 20a.

Here, the organic material vapor generator 8 has a heating chamber 31 with the inside partitioned into two sections with a partition 35, and the evaporation chamber 20a is configured in one section, while a gas heating unit 30a is configured in the other section.

Although, in the diagram, the heating chamber 31 is disposed outside the vacuum chamber 71, the heating chamber 31 can also be disposed inside the vacuum chamber 71.

An evaporation device 24 is disposed inside the evaporation chamber 20a. This evaporation device 24 is formed of a metal and has an evaporation surface 28 of which a top surface thereof is made smooth and inclined at an angle θ relative to the horizontal direction (0 < θ < 90°).

A heating filter 32 is disposed inside the gas heating unit 30a. This heating filter 32 is configured with porous SiC, net-shape SiC, net laminate made of metal, or another material that is permeable to the gas and is not decomposed or does not discharge gas even when the temperature is raised to high temperatures.

A heater 39 is disposed on side faces, a bottom face, and a surface of the heating chamber 31, and is configured so as to raise the temperature of the heating chamber 31 as the heater 39 is electrified by a heating power source 38 for heat generation, and the heating filter 32 and the evaporation device 24 are heated by the heat transfer and the radiation from the heating chamber 31. Induction heating coils may also be disposed outside the heating chamber 31 for induction heating of the heating filter 32 and the evaporation device 24 by alternating magnetic fields.

A connection pipe 23 is disposed inside the heating chamber 31 across the gas heating unit 30a and the evaporation chamber 20a. The partition 35 is made of a material that does not allow a gas to pass therethrough, and one end of the connection pipe 23 is opened in the evaporation chamber 20a and the other end is opened in the gas heating unit 30a; thus, the gas heating unit 30a and the evaporation chamber 20a are connected to each other by the connection pipe 23. The gas inside the gas heating unit 30a can move to the evaporation chamber 20a through the connection pipe 23.

The evaporation chamber 20a is connected to the above discussed vacuum evacuation system 83; and when the evaporation chamber 20a is vacuum-evacuated, the gas within the gas heating unit 30a is also vacuum-evacuated via the connection pipe 23 and the insides of the evaporation chamber 20a and the gas heating unit 30a can be made to be at a vacuum ambience. During the vapor generation, however, the evaporation chamber 20a and the vacuum evacuation system 83 are blocked so as not to evacuate the generated vapor.

A carrier gas supply system 34 is connected to the gas heating unit 30a. From the carrier gas supply system 34, a carrier gas is supplied which is composed of a noble gas (such as Ar and Xe), which does not react with the organic material. (In a case which the organic material vapor reacts with a nitrogen gas, the nitrogen gas is not suitable for the carrier gas.) As the carrier gas is supplied from the carrier gas supply system 34 to the gas heating unit 30a, the carrier gas enters the inside of the connection pipe 23 through the pores and the mesh of the heating filter 32 and flows in the connection pipe 23 so as to be introduced into the evaporation chamber 20a.

The heating filter 32 is heated by the heater 39, and the carrier gas is heated to a temperature higher than the evaporation temperature of the organic material, and lower than the decomposition temperature of the organic material while passing through the heating filter 32.

The supply unit 40 has a tank chamber 41 and a raw material supply pipe 42, and the tank chamber 41 is disposed above the evaporation chamber 20a.

The raw material supply pipe 42 has an upper end air-tightly connected to a lower end of the tank chamber 41, and has a lower end air-tightly inserted inside the evaporation chamber 20a. The inside of the tank chamber 41 and the inside of the evaporation chamber 20a are connected to each other via the raw material supply pipe 42; and when the inside of the evaporation chamber 20a is vacuum-evacuated, the inside of the tank chamber 41 and the inside of the raw material supply pipe 42 are also vacuum-evacuated.

The tank chamber 41 is sealed; and the air atmosphere does not enter while the tank chamber 41, the raw material supply pipe 42, and the evaporation chamber 20a are vacuum-evacuated.

Inside the raw material supply pipe 42, a rotary shaft 46 is disposed that has the side face with screw threads and screw grooves formed therein. Here, the raw material supply pipe 42 and the rotary shaft 46 are disposed vertically.

The screw threads of the rotary shaft 46 and the inner wall surface of the raw material supply pipe 42 are in contact with or are adjacent with a slight gap to each other; and the inside of the tank chamber 41 is connected to the evaporation chamber 20a via the screw grooves. The inclination angle of the screw grooves relative to the horizontal direction is small, and in a stationary state of the rotary shaft 46, even when powder smaller than the size of the screw grooves is disposed inside the tank chamber 41, it does not fall down into the evaporation chamber 20a.

Inside the tank chamber 41, the organic material in powder form is disposed in which the base material of the organic thin film and a color producing reagent are mixed. In the tank chambers 41 of the three film forming apparatuses 10a to 10c, an organic material is respectively disposed and respectively emits light in one color of R, G and B. A reference numeral 48 in the diagram denotes the organic material disposed in the tank chamber 41.

Although the organic material 48 in the tank chamber 41 does not move in a state such that the rotary shaft 46 is stationary, when the rotary shaft 46 is rotated by activating a rotary driver (motor 49) connected to the rotary shaft 46, the organic material 48 enters the inside of the raw material supply pipe 42 through the screw grooves in order to move below along the screw grooves of the raw material supply pipe 42.

The raw material supply pipe 42 is configured such that its lower end is inserted inside the evaporation chamber 20a and connected to the connection pipe 23; and the inside of the raw material supply pipe 42 and the inside of the connection pipe 23 communicate with each other.

The lower end of the screw grooves is opened in the raw material supply pipe 42, and the organic material having reached the lower end of the screw grooves by moving below due to the rotation of the rotary shaft 46 drops onto the inner circumference face of the connection pipe 23 from the inside of the screw grooves.

When the rotary shaft 46 is slowly rotated, the amount of movement of the organic material within the screw grooves and the amount of rotation of the rotary shaft 46 are in one to one relationship, and if the relationship between the amount of rotation and the amount of drop is obtained in advance, it becomes possible to drop the organic material in a desired amount from the raw material supply pipe 42. When it is slowly rotated, it is possible to continuously drop the material by a small amount.

The connection pipe 23 is configured such that the portion between the end position of the evaporation chamber 20a and the position at which the organic material is dropped is tilted and an opening 26 at the end of the connection pipe 23 is made lower than the drop position. Consequently, the organic material having dropped onto the inner circumference face of the connection pipe 23 slides down towards the opening 26 on the inner circumference face of the connection pipe 23.

The opening 26 is disposed immediately above the evaporation surface 28 of the evaporation device 24, and the organic material having reached the opening 26 drops on the evaporation surface 28 from the opening 26.

The organic material 48 having dropped onto the evaporation surface 28 is dispersed on the evaporation surface 28. Since the evaporation surface 28 is tilted, the organic material slides down on the evaporation surface 28 in a spread state.

Although the organic material that drops onto the evaporation surface 28 is in a powder state at room temperature, the organic material evaporates and organic material vapor is produced when the organic material is heated to the evaporation temperature or higher. The evaporation device 24 is raised to a temperature higher than the evaporation temperature of the organic material by the heater 39 in advance. Since the organic material is supplied on the evaporation surface 28 in an amount that is allowed to be fully evaporated before the material has slid down the evaporation surface 28 and reaches the lower end (that is, while sliding down). The organic material starts evaporation immediately after being dispersed on the evaporation surface 28 and evaporates while sliding down to disappear from the evaporation surface 28 without reaching the lower end.

When the organic material is dropped onto the evaporation surface 28, the vacuum evacuation in the vacuum chamber 71 is performed while the valve between the evaporation chamber 20a and the vacuum evacuation system 83 is closed so as to prevent the organic material vapor produced in the evaporation chamber 20a from vacuum-evacuating by the evaporation of the organic material without passing through the discharger 70.

The evaporation chamber 20a and the discharger 70 are connected to each other by the supply pipe 27. When the organic material is dropped onto the evaporation surface 28, the carrier gas is supplied to the gas heating unit 30a prior to the organic material being dropped so as to introduce the heated carrier gas into the evaporation chamber 20a.

As the opening 26 of the connection pipe 23 in which the heated carrier gas flows is directed to the portion of the evaporation surface 28 where the organic material evaporates and the heated carrier gas is sprayed to the portion, the organic material vapor and the heated carrier gas are uniformly mixed in the evaporation chamber 20a, and the mixed gas is introduced into the vapor discharge pipes 72 through the supply pipe 27.

By controlling the flow rate of the carrier gas supplied from the carrier gas supply system 34 to the gas heating unit 30a, the internal pressure of the vapor discharge pipes 72 is set at such a magnitude that forms a viscous flow of the mixed gas (mixed gas of the carrier gas and the organic material vapor) inside the vapor discharge pipes 72 so that the inside of each vapor discharge pipe 72 is filled with the mixed gas of an approximately equal pressure from the base through the end. The inside of the vacuum chamber 71 is continuously and directly vacuum-evacuated, and the ambient pressure of the vapor discharge pipes 72 is lower than the internal pressure of the vapor discharge pipes 72. As a result, the mixed gas is discharged from each discharge orifice 73 at an equal flow rate respectively, and the organic material vapor reaches the surface of the substrate 5 at a uniform density per unit area through the passage holes 76 of the cooling plate 75 and the through holes 78 of the mask 77.

By introducing the carrier gas, even in the case where the organic material vapor is introduced in a small amount, the pressure inside the vapor discharge pipes 72 can be made at a pressure that makes it possible to discharge vapor through the discharge orifices 73 uniformly between the end and the base portion.

Also in the case where the generation amount of the organic material vapor is changed, it is possible to adjust the pressure inside the vapor discharge pipes 72 by changing the introduction amount of the carrier gas. Accordingly, it becomes possible to vary the generation amount of organic material vapor (that is, to adjust the film deposition rate).

In the case of the present invention, since the organic material vapor reaches the surface of the substrate in an equal amount in the region from the base through the end of each vapor discharge pipe 72, an organic thin film without unevenness can be obtained.

Further, the film forming chamber 9 of the present invention is provided with a shifter 85. Whereas the substrate holder 79, the substrate 5, and the mask 77 are relatively stationary and the discharger 70 and the cooling plate 75 are also relatively stationary, the substrate 5 and each vapor discharge pipe 72 are configured to relatively move due to the shifter 85.

The directions of movement are directions perpendicular to the extending directions of the vapor discharge pipes 72 without changing the distance between the plane where the substrate 5 is positioned and the plane where the vapor discharge pipes 72 are positioned. As the relatively reciprocating movement is repeated in such directions, a uniform organic thin film is formed on the surface of the substrate 5.

The relative movement may also be arranged such that the substrate 5 (and the substrate holder 79 and the mask 77) is stationary relative to the vacuum chamber 71 and the discharger 70 (and the cooling plate 75) moves relative to the vacuum chamber 71. It may also be in such a way that the discharger 70 is stationary relative to the vacuum chamber 71 and the substrate 5 moves relative to the vacuum chamber 71. Both the substrate 5 and the discharger 70 may also be arranged to move.

Furthermore, the directions of relative movement may also have, in addition to the component of a direction perpendicular to the extending directions of the vapor discharge pipes 72, a component parallel to that and may also be arranged to relatively move in a circle.

As discussed above, after forming the organic thin film that emits in one of the colors of R, G and B at a predetermined position on the substrate 5 by the first film forming apparatus 10a, the substrate 5 is first moved into the next film forming apparatuses 10b and 10c sequentially by the substrate transfer robot 53 in order to form organic thin films corresponding to the rest of the colors, respectively at predetermined positions on the substrate 5. Then, the substrate 5 is carried in other processing chambers 55 to 58 as needed for vacuum processing (such as, formation of charge transfer layers and electrode films), and then the substrate is carried out of the vacuum processing apparatus 1.

In the present invention, the heating chamber 31 and the carrier gas are raised to a temperature higher than the evaporation temperature of the organic material (here, the evaporation temperature is assumed to be equal to the precipitation temperature) and temperature of the organic material vapor does not become deposition temperature or lower, so that the organic material does not deposit inside the heating chamber 31.

In the present invention, the organic material is supplied from the supply unit 40 to the evaporation chamber 20a at a supply speed such that the organic material dropped onto the evaporation surface 28 evaporates while sliding down the evaporation surface 28; and when the drop of the organic material onto the evaporation surface 28 is stopped, the organic material in a powder state on the evaporation surface 28 immediately disappears. Consequently, the production of the organic material vapor is also stopped almost at the same time when the supply of the organic material from the supply unit 40 to the evaporation chamber 20a is stopped.

Further, in the evaporation chamber 20a, the pressure of the heated carrier gas is arranged to be higher than the pressure of the produced organic material vapor, and as a result, a small amount of the organic material gas is carried into the discharger 70 with a large amount of the heated carrier gas flow, so that when the supply of the organic material from the supply unit 40 to the evaporation device 24 is stopped, the generation of the organic material vapor inside the evaporation chamber 20a is immediately stopped. Further, the organic material vapor filling the evaporation chamber 20a immediately moves into the discharger 70 due to the heated carrier gas, and the organic material vapor is immediately discharged. Consequently, when the supply of the organic material from the supply unit 40 is stopped while the carrier gas is made to flow, the organic material vapor is quickly purged, so that the time until the film formation is stopped can be shortened. Also, the insides of the evaporation chamber 20a, the supply pipe 27, and the discharger 70 can be certainly purged.

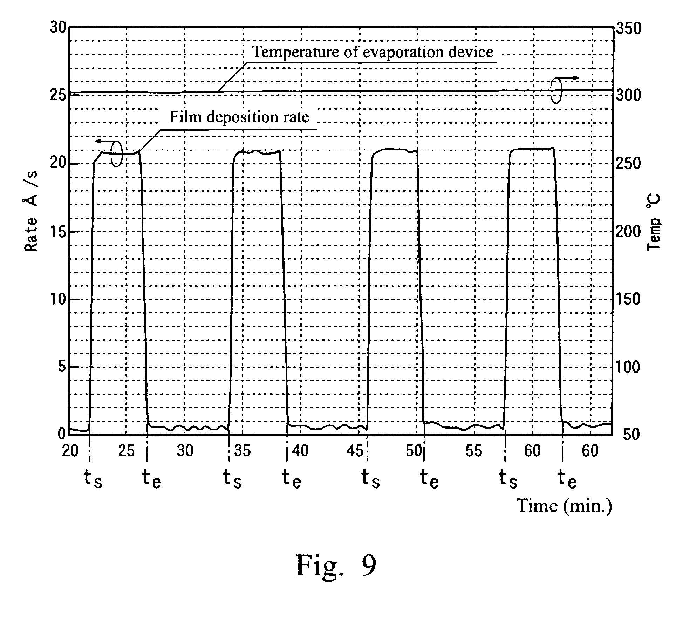

Fig. 9 is a graph showing the relationship between time and the measurements of the film thickness monitors disposed at the positions facing the vapor discharge pipe 72 when the organic material is dropped onto the evaporation device 24 at predetermined time intervals while maintaining the temperature of the evaporation device 24 at a constant temperature of about 300°C.

From a time tₛ when the supply of the organic material to the evaporation device 24 is started until a time tₑ when the supply is stopped, a constant film deposition rate is obtained, and from a time tₑ when the supply is stopped until a time tₛ when the supply is restarted, the raw material is not supplied and the film deposition rate is zero although margin of error of the film thickness monitors are observed.

In such a manner, since a thin film can be formed on the surface of the substrate 5 only during the supply of the organic material onto the evaporation device 24 while flowing the heated carrier gas from the gas heating unit 30a, it is not necessary to provide a shutter between the discharger 70 and the substrate 5; and also, the discharge of the organic material vapor from the discharger 70 can be started or stopped without the opening or closing of the opening-closing valve between the evaporation chamber 20a and the discharger 70.

In order to form an organic thin film on a plurality of substrates in series at the insides of each of the film forming apparatuses 10a, 10b and 10c, the supply of the organic material from the supply unit 40 to the evaporation chamber 20a is stopped while the object to be film-formed of which the organic thin film had been formed thereon is transferred from the substrate holder 79 and an unformed object to be film-formed is subsequently disposed on the substrate holder 79. After disposing the object to be film-formed before film formation on the substrate holder 79, the supply of the organic material from the supply unit 40 to the evaporation chamber 20a is restarted to start film formation.

In addition to the state that occurs after the restart of the organic material supply, if the heated carrier gas is continuously flown into the evaporation chamber 20a, the supply pipe 27, and the discharger 70 during the replacement of the substrates, the temperature of the heating filter is constantly maintained, and the temperature of the mixed gas discharged from the discharger 70 also becomes constant so that the film quality of the formed organic thin film becomes less varied.

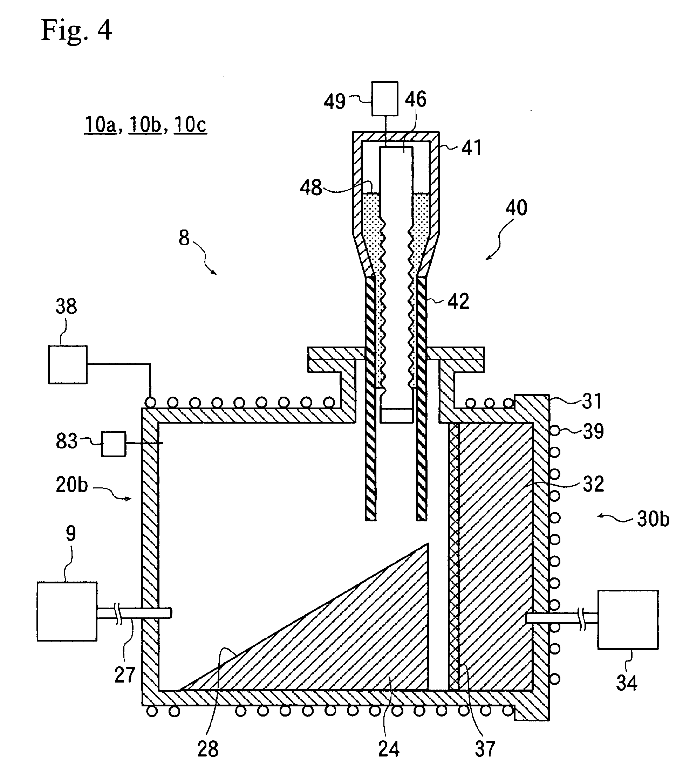

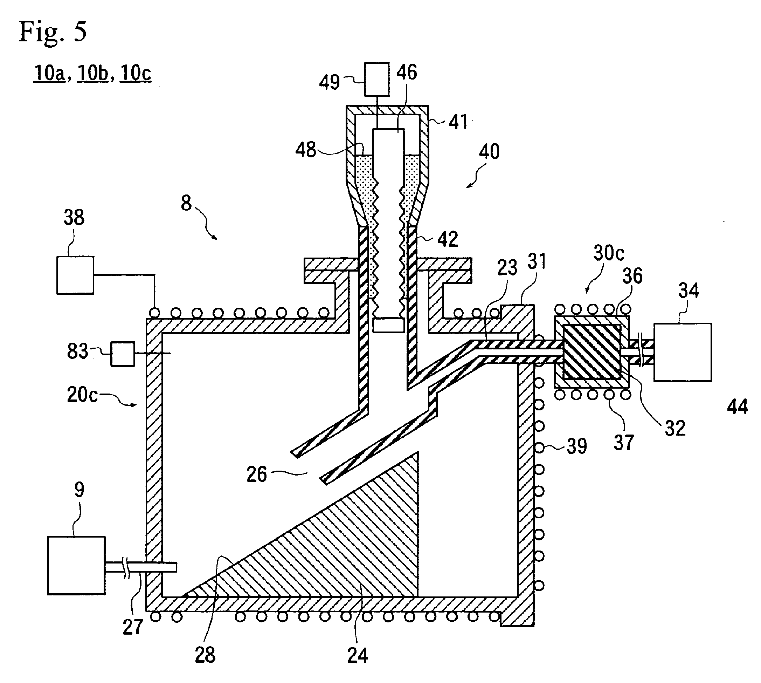

In the above-discussed Example, the inside of the heating chamber 31 is partitioned with the partition 35, which does not allow gas to pass therethrough; the inside of the heating chamber 31 may also be partitioned with an air permeable plate 37 that allows a gas to pass therethrough; and an evaporation chamber 20b and a gas heating unit 30b are formed as shown in Fig. 4. The carrier gas heated when passing through the heating filter 32 in the heating unit 30b is introduced into the evaporation chamber 20b through the air permeable plate 37. In this case, connection pipe that connects the evaporation chamber 20b and the gas heating unit 30b is not necessary, and as the evaporation device 24 is disposed immediately below the raw material supply pipe 42, the organic material can be dropped from the raw material supply pipe 42 onto the evaporation surface 28 without passing through the connection pipe. Although, in the embodiments as above-discussed, the heating units 30a and 30b are disposed inside the heating chamber 31, the present invention is not limited to those embodiments and, as illustrated in Fig. 5, a gas heating unit 30c can also be disposed outside the heating chamber 31. In this case, the entire inside of the heating chamber 31 may also be taken as an evaporation chamber 20c and the heating chamber 31 and the heating chamber 31 may also be connected by the connection pipe 23.

In this example, the lower end of the raw material supply pipe 42 can also be connected to the connection pipe 23, and the organic material dropped from the raw material supply pipe 42 slides down inside the connection pipe 23 and then, the organic material drops onto the evaporation surface 28.

As discussed above, in the present invention, the carrier gas is heated higher than the evaporation temperature of the organic material, so that the evaporation chamber 20a and the supply pipe 27 are not cooled down and the organic material vapor does not deposit therein. It is also possible to dispose a heater on the outer circumference of the supply pipe 27 to heat the supply pipe 27.

The heater, which heats the heating chamber 31 and the supply pipe 27, heats the evaporation device 24, the supply pipe 27, and the carrier gas so as to raise the temperature lower than the decomposition temperature of the organic material, so that the organic material is not decomposed.

Although, in the Examples discussed above, the supply unit 40 has the raw material supply pipe 42, the rotary shaft 46 disposed therein, and the motor 49 to rotate the rotary shaft 46, the supply unit 40 is not limited thereto, and may be a supply unit that can supply a predetermined amount of the organic material on the evaporation surface 28 by driblets.

It should be noted that, since the film thickness of an organic thin film formed on the surface of one substrate 5 is generally determined in advance and almost all the organic material vapor produced in the evaporation chamber 20a is discharged from the discharger 70, it is possible to obtain the amount of the organic material of which the supply unit 40 should supply for formation of an organic thin film having a film thickness determined in advance.

Since, as the film deposition rate for an organic thin film is determined, the supply speed of the organic material, which is supplied to the evaporation chamber 20a by the supply unit 40 is also determined, the rotation speed of the rotary shaft is determined so as to obtain the supply speed.

The tank chamber 41 is not heated, the supply unit 40 is cooled down, and the organic material existing in the tank chamber 41 and the supply unit 40 is maintained at room temperature approximately.

In the present invention, the organic material is supplied into the evaporation chamber 20a by a small amount, so that the organic material in the tank chamber 41 and the supply unit 40 is maintained at room temperature approximately and it is possible to prevent decomposition due to heating.

Furthermore, although the carrier gas is heated by flowing the carrier gas into the porous or net-shape heating filter at a raised temperature in the above-discussed examples, the temperature may also be raised by flowing the carrier gas into various heat exchangers.

In a case that the film thickness and the film deposition rate of the organic thin film to be formed are defined, the film forming time period and the supply speed (amount of supply per unit time period) can be calculated from the amount of the organic material obtained from the film thickness and the defined film deposition rate, so that the rotary shaft 46 can be continuously rotated during the film forming time period at a rotation speed calculated from the obtained supply speed, and the organic material can be intermittently dropped by intermittently rotating the rotary shaft 46 in a short cycle such that the organic material is supplied in the obtained amount within the film forming time period.

## Claims

1. A film forming apparatus (10a, 10b, 10c), comprising:
a vacuum chamber (71); and
a film forming source discharging an organic material vapor inside the vacuum chamber, and
the film forming source including:
an elongate vapor discharge pipe (172) having a plurality of discharge orifices (173) formed along a longitudinal direction thereof, and
an organic material vapor (8) generator connected to the vapor discharge pipe (172); and
the organic material vapor generator (8) including:
an evaporation chamber (20a),
a supply unit (40) connected to the evaporation chamber for supplying an organic material (48) in powder form inside the evaporation chamber,
an evaporation device (24) disposed in the evaporation chamber for evaporating the organic material (48) supplied from the supply unit (40), and
a gas heating unit (30a) heating a carrier gas,
wherein the evaporation chamber (20a) is configured to introduce therein the carrier gas heated by the gas heating unit (30a),
wherein a supply pipe (27) connects one end of the vapor discharge pipe (172) and the evaporation chamber (20a), and
wherein the vapor discharge pipe (172) is disposed inside the vacuum chamber (71),
wherein the supply unit (40) includes a raw material supply pipe (42) and a rotary shaft (46) inserted in the raw material supply pipe (42) and the organic material (48) is disposed between the raw material supply pipe (42) and the rotary shaft (46),
wherein screw threads and screw groves are formed on a side face of the rotary shaft (46), and when the rotary shaft (46) is rotated the organic material (48) disposed between the raw material supply pipe (42) and the rotary shaft (46) is moved through the screw grooves,
wherein the evaporation device (24) has an evaporation surface inclined to a horizontal direction,
wherein the supply unit (40) has a pipe (23) connected to the raw material supply pipe (42),
wherein the supply unit (40) is configured such that the organic material (48) supplied from the supply unit (40) by rotation of the rotary shaft (46) drops onto the evaporation surface (24) via the pipe (23) and slides down on the evaporation surface (24) so as to evaporate, and
wherein the carrier gas is introduced into the pipe (23) where the organic material (48) moves through.

2. The film forming apparatus (10a, 10b, 10c) according to claim 1,
wherein the vapor discharge pipe (172) is disposed horizontally,
wherein the discharge orifices (173) are directed below, and
wherein an object to be film-formed carried in the vacuum chamber (71) is disposed below the vapor discharge pipe (172).

3. The film forming apparatus (10a, 10b, 10c) according to claim 2, further comprising:
a plurality of the vapor discharge pipes (172) disposed parallel to each other; and
a shifter (85) relatively moving the object to be film-formed and the vapor discharge pipe (172) in a direction perpendicular to an extending direction of the vapor discharge pipe (172) and in the horizontal direction.

## Patentansprüche

1. Filmbildungsvorrichtung (10a, 10b, 10c), aufweisend:
eine Vakuumkammer (71); und
eine Filmbildungsquelle, die einen organischen Materialdampf in der Vakuumkammer entlädt,
wobei die Filmbildungsquelle enthält:
eine längliche Dampfentladungsröhre (172), die mehrere Entladungsöffnungen (173) aufweist, die entlang ihrer Längsrichtung gebildet sind, und
einen Erzeuger (8) von organischem Materialdampf, der mit der Dampfentladungsröhre (172) verbunden ist; und
wobei der Erzeuger (8) von organischem Materialdampf enthält:
eine Verdampfungskammer (20a),
eine Versorgungseinheit (40), die mit der Verdampfungskammer verbunden ist, um das Innere der Verdampfungskammer mit einem organischen Material (48) in Puderform zu versorgen,
eine Verdampfungsvorrichtung (24), die in der Verdampfungskammer zum Verdampfen des organischen Materials (48) angeordnet ist, das von der Versorgungseinheit (40) geliefert wird, und
eine Gasheizeinheit (30a), die ein Trägergas heizt,
wobei die Verdampfungskammer (20a) dazu ausgelegt ist, das von der Gasheizeinheit (30a) aufgeheizte Gas einzulassen,
wobei eine Versorgungsröhre (27) ein Ende der Dampfentladungsröhre (172) und die Verdampfungskammer (20a) verbindet, und
wobei die Dampfentladungsröhre (172) in der Vakuumkammer (71) angeordnet ist,
wobei die Versorgungseinheit (40) eine Rohmaterial-Versorgungsröhre (42) und eine Drehachse (46) enthält, die in die Rohmaterial-Versorgungsröhre (42) eingeführt ist, und das organische Material (48) zwischen der Rohmaterial-Versorgungsröhre (42) und der Drehachse (46) angeordnet ist,
wobei Schraubengewinde und Schraubenrillen auf einer Seitenfläche der Drehachse (46) gebildet sind, und wenn die Drehachse (46) gedreht wird, das organische Material (48), das zwischen der Rohmaterial-Versorgungsröhre (42) und der Drehachse (46) angeordnet ist, durch die Schraubenrillen bewegt wird,
wobei die Verdampfungsvorrichtung (24) eine Verdampfungsfläche aufweist, die zu einer horizontalen Richtung geneigt ist,
wobei die Versorgungseinheit (40) eine Röhre (23) aufweist, die mit der Rohmaterial-Versorgungsröhre (42) verbunden ist,
wobei die Versorgungseinheit (40) derart ausgelegt ist, dass das organische Material (48), das durch Rotation der Drehachse (46) von der Versorgungseinheit (40) geliefert wird, über die Röhre (23) auf die Verdampfungsfläche (24) tropft und die Verdampfungsfläche (24) hinunterrutscht, um zu verdampfen, und
wobei das Trägergas in die Röhre (23) eingelassen wird, durch die sich das organische Material (48) bewegt.

2. Filmbildungsvorrichtung (10a, 10b, 10c) gemäß Anspruch 1,
wobei die Dampfentladungsröhre (172) horizontal angeordnet ist,
wobei die Entladungsöffnungen (173) nach unten gerichtet sind, und
wobei ein Objekt zur Filmbildung, das in der Vakuumkammer (71) getragen wird, unterhalb der Dampfentladungsröhre (172) angeordnet ist.

3. Filmbildungsvorrichtung (10a, 10b, 10c) gemäß Anspruch 2, ferner aufweisend:
mehrere Dampfentladungsröhren (172), die parallel zueinander angeordnet sind; und
eine Schiebeeinheit (85), die das Objekt zur Filmbildung und die Dampfentladungsröhre (172) in einer Richtung senkrecht zu einer Ausdehnungsrichtung der Dampfentladungsröhre (172) und in der horizontalen Richtung relativ bewegt.

## Revendications

1. Appareil de formation d'un film (10a, 10b, 10c) comprenant :
une chambre de vide (71) ; et
une source de formation de film déchargeant une vapeur de matériau organique à l'intérieur de la chambre de vide, et
la source de formation de film incluant :
un tuyau d'évacuation de vapeur oblong (172) comportant une pluralité d'orifices d'évacuation (173) formés dans sa direction longitudinale, et
un générateur de vapeur de matériau organique (8) relié au tuyau d'évacuation de vapeur (172) ; et
le générateur de vapeur de matériau organique (8) incluant :
une chambre d'évaporation (20a),
une unité d'alimentation (40) reliée à la chambre d'évaporation pour fournir un matériau organique (48) sous forme de poudre à l'intérieur de la chambre d'évaporation,
un dispositif d'évaporation (24) disposé dans la chambre d'évaporation pour l'évaporation du matériau organique (48) fourni par l'unité d'alimentation (40), et
une unité de chauffage de gaz (30a) chauffant un gaz porteur,
où la chambre d'évaporation (20a) est configurée pour introduire dans celle-ci le gaz porteur chauffé par l'unité de chauffage de gaz (30a),
où un tuyau d'amenée (27) relie une extrémité du tuyau d'évacuation de vapeur (172) et la chambre d'évaporation (20a),
où le tuyau d'évacuation de vapeur (172) est disposé à l'intérieur de la chambre de vide (71),
où l'unité d'alimentation (40) comprend un tuyau d'amenée de matériau brut (42) et un arbre de rotation (46) inséré dans le tuyau d'amenée de matériau brut (42), et le matériau organique (48) est disposé entre le tuyau d'amenée de matériau brut (42) et l'arbre de rotation (46),
où des filetages de vis et des rainures de vis sont formés sur une face latérale de l'arbre de rotation (46), et lorsque l'arbre de rotation (46) est amené à tourner, le matériau organique (48) disposé entre le tuyau d'amenée de matériau brut (42) et l'arbre de rotation (46) est amené à passer à travers les rainures de vis,
où le dispositif d'évaporation (24) possède une surface d'évaporation inclinée dans la direction horizontale,
où l'unité d'alimentation (40) comporte un tuyau (23) relié au tuyau d'amenée de matériau brut (42),
où l'unité d'alimentation (40) est configurée de façon que le matériau organique (48) fourni par l'unité d'alimentation (40) par la rotation de l'arbre de rotation (46) tombe sur la surface d'évaporation (24) par le tuyau (23) et glisse le long de la surface d'évaporation (24) de manière à s'évaporer, et
où le gaz porteur est introduit dans le tuyau (23) à travers lequel le matériau organique (48) se déplace.

2. Appareil de formation de film (10a, 10b, 10c) selon la revendication 1, dans lequel le tuyau d'évacuation de vapeur (172) est disposé horizontalement,
où les orifices d'évacuation (173) sont dirigés en dessous, et
où un objet destiné à être pourvu d'un film supporté dans la chambre de vide (71) est disposé en dessous du tuyau d'évacuation de vapeur (172).

3. Appareil de formation de film (10a, 10b, 10c) selon la revendication 2, comprenant en outre :
une pluralité de tuyaux d'évacuation de vapeur (172) disposés parallèlement les uns aux autres, et
un organe de décalage (85) déplaçant relativement l'objet destiné à être pourvu d'un film et le tuyau d'évacuation de vapeur (172) dans une direction perpendiculaire à une direction d'extension du tuyau d'évacuation de vapeur (172) et dans la direction horizontale.
